# EUROPÄISCHE PATENTANMELDUNG

(11) **EP 0 903 787 A2**
(43) Veröffentlichungstag der Anmeldung: **24.03.1999**
(21) Anmeldenummer: 98116217.5
(22) Anmeldetag: 27.08.1998
(51) Int. Cl.: H01L 29/732

(54) **Anordnung zur Reduktion von Rauschen bei Mikrowellentransistoren und Verfahren zu deren Herstellung**

(30) Priorität: 17.09.1997 DE 19740909
(71) Anmelder: SIEMENS AKTIENGESELLSCHAFT, 80333 München (DE)
(72) Erfinder: Knapp, Herbert, 80798 München (DE); Aufinger, Klaus, 85521 Ottobrunn (DE)

(57) **Zusammenfassung**

Der Anmeldungsgegenstand betrifft eine Anordnung, bei der die minimale Rauschzahl dadurch reduziert wird, daß unterhalb der Basisanschlußfläche eine hoch dotierte vergrabene Schicht (BL') hergestellt wird, die in der Nähe der Basisanschlußfläche über einen Standard-Kollektorkontakt (CC') mit Bezugspotential (GRD) verbunden ist. Vorteilhaft ist hierbei die Senkung der minimalen Rauschzahl ohne zusätzliche Prozeßschritte.

## Beschreibung

Die Erfindung betrifft die Minimierung der Rauschzahl bei Mikrowellentransistoren. Diese Rauschzahl ist, wie der Name bereits sagt, ein Maß für das Rauschen eines Bauelements und wird mit immer kleineren Abmessungen der Bauelemente und immer höheren Betriebsfrequenzen zunehmend durch den Einfluß der parasitären Elemente am Chip, zum Beispiel Leitungen, Kontaktflächen und dem Substratwiderstand, beeinflußt.

Aus dem IEEE Paper zum Microwave and Millimeter-Wave Monolithic Circuits Symposium, 1994, pp. 225 bis 228, ist beispielsweise eine Modellierung mit Ersatzschaltbildern bekannt, die zeigt, daß beispielsweise die parasitären Effekte aufgrund der Anschlußpads mit steigender Frequenz einen starken Einfluß auf die Rauschzahl haben.

Die der Erfindung zugrundeliegende Aufgabe liegt nun darin, eine Anordnung zur Reduktion von Rauschen bei Mikrowellentransistoren anzugeben, bei der die Verkleinerung der Rauschzahl des Transistors auf möglichst einfache Weise und möglichst ohne Änderung üblicher Herstellungsprozesse für Mikrowellentransistoren in Silizium-Bipolar-Technologie durchführbar ist. Diese Aufgabe wird hinsichtlich der Anordnung durch die Merkmale des Patentanspruchs 1 und hinsichtlich des Herstellverfahrens durch die Merkmale des Anspruchs 5 gelöst. Die Patentansprüche 2 bis 4 betreffen vorteilhafte Weiterbildungen der erfindungsgemäßen Anordnung.

Die Erfindung wird nachfolgend anhand eines bevorzugten Ausführungsbeispiels in der Zeichnung näher erläutert. Dabei zeigt
- Figur 1: eine Draufsicht des Ausführungsbeispiels,
- Figur 2: eine Schnittdarstellung des Ausführungsbeispiels,
- Figur 3: ein Diagramm, das für eine übliche Anordnung mit einem Mikrowellentransistor den Einfluß des Substratwiderstands auf die minimale Rauschzahl über der Frequenz zeigt und
- Figur 4: eine Schnittdarstellung eines üblichen Mikrowellentransistors zur Erläuterung des Herstellungsverfahrens.

Die Rauschzahl wird auf einfache Weise dadurch reduziert, daß unter die Basisanschlußfläche eine niederohmige vergrabene Schicht ins Substrat eingebracht wird, die in der Nähe des Basisanschlusses über einen Standard-Kollektorkontakt mit Bezugspotential verbunden ist. Da die Rauschzahl der gesamten Anordnung nicht nur vom eigentlichen aktiven Bauelement, sondern auch von der Dimensionierung der Elemente eines parasitären RC-Glieds zwischen dem Basisanschluß und Bezugspotential abhängt, wird die Rauschzahl der Anordnung aufgrund einer niederohmigen Masseverbindung des Kondensators des parasitären RC-Glieds gesenkt. Vorteilhafterweise kann eine vergrabene Schicht, gegebenenfalls eine durch Tiefenimplantation erzeugte Schicht und auch die metallische Verbindung dieser Schichten mit Massepotential im gleichen Prozeß wie die Schichten zwischen dem Kollektor und dem Kollektoranschluß und der Schicht für den Kollektoranschluß selbst gebildet werden.

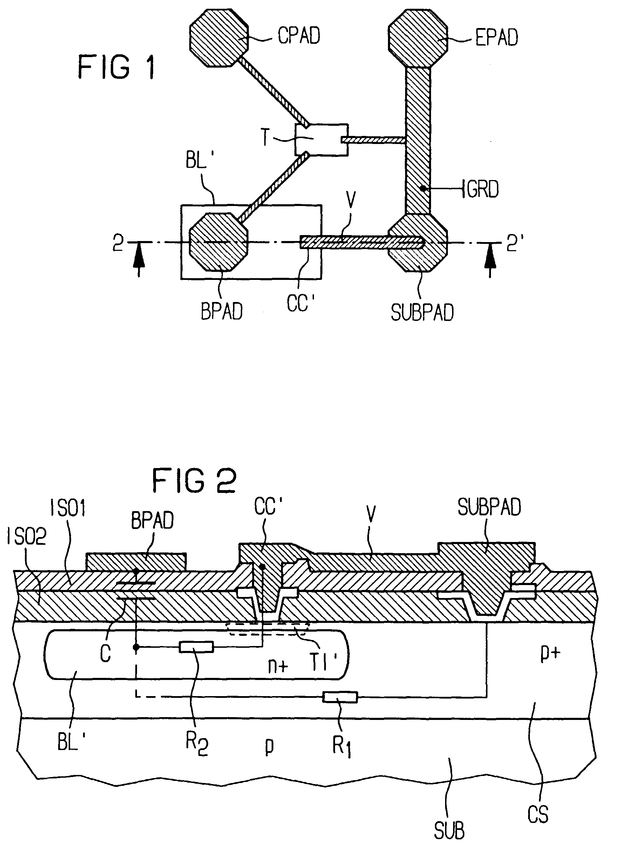

In Figur 1 ist eine Anordnung mit einem Mikrowellentransistor T dargestellt, der mit einer Kollektoranschlußfläche CPAD, einer Basianschlußfläche BPAD und einer Emitteranschlußfläche EPAD verbunden ist, wobei die Emitteranschlußfläche mit einer Substratanschlußfläche SUBPAD zur Kontaktierung eines Substrats verbunden und auf Masse (GRD) gelegt ist. Im lateralen Bereich der Basisanschlußfläche und in Richtung zur Substratanschlußfläche SUBPAD erweitert ist eine laterale Begrenzungslinie einer vergrabenen Schicht BL' in Form eines Rechtecks angedeutet. Zwischen dem Substratanschluß SUBPAD und dem lateralen Bereich der vergrabenen Schicht BL' ist eine stegartige Metall-Verbindung V gezeigt, die bis innerhalb des lateralen Bereiches der vergrabenen Schicht reicht und eine Kontaktierung CC' aufweist. Schließlich ist eine Schnittlinie 2-2' durch die vergrabene Schicht BL, den Basisanschluß BPAD, den Kontakt CC', die Verbindung V und die Substratanschlußfläche SUBPAD eingezeichnet.

In Figur 2 ist der Schnitt entlang der Linie 2-2' dargestellt, in den zwischen der Basisanschlußfläche EPAD und der vergrabenen Schicht BL', die von der Basisanschlußfläche z. B. durch Isolationsschichten ISO1 und ISO2 getrennt ist, eine parasitäre Kapazität C eingezeichnet ist. Die vergrabene Schicht BL' ist entweder direkt oder über eine zusätzliche tiefimplantierte Schicht TI' mit dem Kontakt CC' verbunden. Der in der vergrabenen Schicht BL' befindliche Anschluß der parasitären Kapazität C ist über einen parasitären Widerstand R2 mit dem Kontakt CC' verbunden, der die vergrabene Schicht BL bzw. die tiefimplantierte Schicht TI' repräsentiert. Wäre die vergrabene Schicht BL' nicht vorhanden, so wäre der in der vergrabenen Schicht BL' befindliche Anschluß der parasitären Kapazität C über einen wesentlich höherohmigen parasitären Widerstand R₁, der gestrichelt gezeichnet ist, mit der Substratanschlußfläche SUBPAD verbunden.

Der Schichtwiderstand der vergrabenen Schicht BL' liegt typischerweise bei ca. 20 bis 40 Ω/□ und ist damit typischerweise um etwa den Faktor 0,1 niedriger als der Schichtwiderstand des Substrats. Sofern zusätzlich eine sich über die gesamte vergrabene Schicht erstreckende tiefimplantierte Schicht TI vorhanden ist, kann nochmals eine Veringerung des Widerstandes um etwa den Faktor 0,5 erreicht werden.

Zwischen der Isolationsschicht ISO2 und dem Substrat SUB befindet sich bei bekannten Transistoren oftmals zusätzlich eine etwas stärker als das Substrat dotierte sogenannte Kanalstoppschicht CS. Die Schicht BL' ist typischerweise um etwa den Faktor 100 höher dotiert als die Schicht CS und ist hier n-leitend, wohingegen die Kanalstoppschicht CS und das Substrat p-leitend sind. Aufgrund der wesentlich höheren Dotierung der vergrabenen Schicht und der größeren Nähe zum Massepotential ist der Widerstand R₂ auch wesentlich niederohmiger als der Widerstand einer herkömmlichen Anordnung mit Kanalstoppschicht.

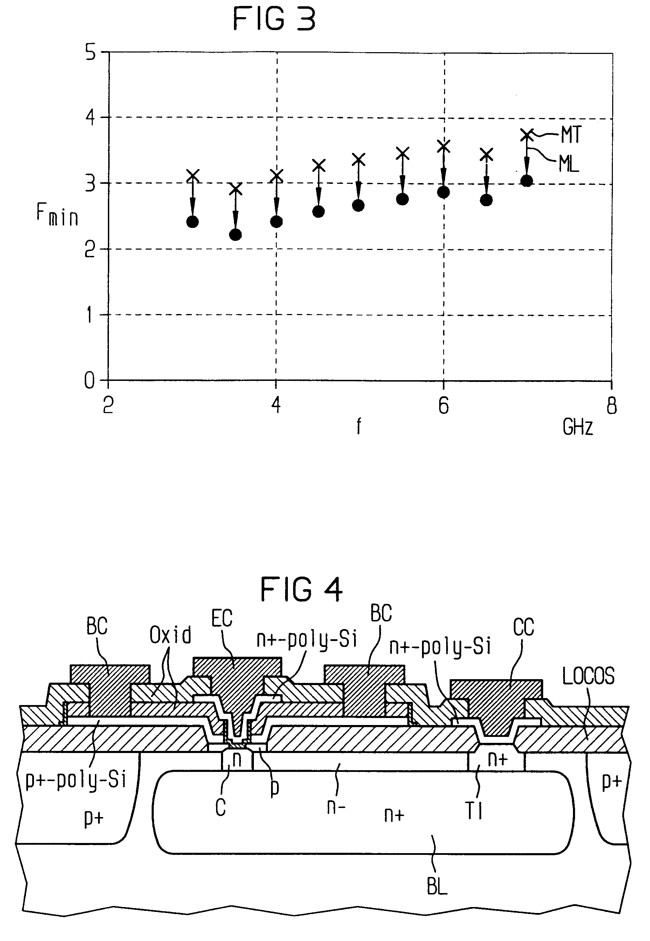

In Figur 3 ist der Einfluß des Substratwiderstandes auf die minimale Rauschzahl anhand einiger über der Frequenz f aufgetragenen Meßwerte dargestellt, wobei die minimal mögliche Rauschzahl jeweils dadurch ermittelt, daß die Rauschzahl einer Anordnung mit Transistor T um die Rauschzahl einer Leeranordung ohne Transistor T vermindert wird. Hieraus wird deutlich, daß die minimale Rauschzahl Fₘᵢₙ bei Frequenzen von etwa 3 GHz um ca. 0,5 und mit steigender Frequenz bis hin zu etwa 0,8 bei einer Frequenz von 7 GHz reduziert werden kann.

In Figur 4 ist ein Schnitt durch einen üblichen Mikrowellentransistor mit der Kontaktierung eines Kollektors C über eine vergrabene Schicht BL und eine tiefimplantierte Schicht TI mit dem Kollektorkontakt CC gezeigt. Aus Figur 4 in Zusammenschau mit Figur 2 wird deutlich, daß die vergrabene Schicht BL', die tiefimplantierte Schicht TI' und der Kontakt CC' kostensparenderweise gleichzeitig im Standardprozeß zur Kontaktierung des Kollektors erzeugt werden können, wobei sich die gemeinsam erzeugten Gegegenstände in ihren Bezugszeichen nur durch einen Strich unterscheiden.

## Patentansprüche

1. Anordnung zur Reduktion Rauschen bei Mikrowellentransistoren,
bei der ein Transistor (T) vorgesehen ist, der mit einer Kollektoranschlußfläche (CPAD), einer Basisanschlußfläche (BPAD) und einer Emitteranschlußfläche (EPAD) verbunden ist, wobei die Emitteranschlußfläche mit einer Substratanschlußfläche (SUBPAD) zur Kontaktierung eines Substrats (SUB) verbunden und auf Masse (GRD) gelegt ist und
bei der unterhalb der Basisanschlußfläche eine von der Basisanschlußfläche isolierte hochdotierte vergrabene Schicht (BL') vorhanden ist, die über einen möglichst dicht neben der Basisanschlußfläche liegenden Kontakt (CC') mit Masse verbunden ist.

2. Anordnung nach Anspruch 1,
bei der zwischen dem Kontakt und der vergrabenen Schicht zusätzlich eine tiefimplantierte Schicht (TI') vorhanden ist, die denselben Leitfähigkeitstyp aufweist, wie die vergrabene Schicht aber höher als diese dotiert ist

3. Anordnung nach Anspruch 2,
bei der sich die tiefimplantierte Schicht (TI') im wesentlichen über die gesamte vergrabene Schicht (BL') erstreckt.

4. Anordnung nach einem der Ansprüche 1 bis 3,
bei der der Kontakt (CC') über eine metallische Verbindung (V) mit der Substratanschlußfläche, der Emitteranschlußfläche oder einer Verbindungsfläche zwischen den beiden verbunden ist.

5. Verfahren zur Herstellung einer der Anordnungen nach den vorhergehenden Ansprüchen,
bei dem die vergrabene Schicht (BL') gemeinsam mit der vergrabenen Schicht (BL) des Transistors (T), der Kontakt (CC') gemeinsam mit dem Kollektorkontakt (CC) des Transistors und die tiefimplantierte Schicht (TI') gleichzeitig im selben Prozeß wie eine tiefimplantierte Schicht (TI) zwischen dem Kollektorkontakt des Transistors und der vergrabenen Schicht des Transistors gebildet werden.
